Europäisches Patentamt

European Patent Office

Office européen des brevets

(11) Veröffentlichungsnummer: **0 004 333**
B1

(12) **EUROPÄISCHE PATENTSCHRIFT**

(45) Veröffentlichungstag der Patentschrift:
25.11.81

(21) Anmeldenummer: 79100745.3

(22) Anmeldetag: 12.03.79

(51) Int. Cl.³: **H 01 L 23/46**

(54) Verfahren zur Kühlung elektrischer Bauelemente mittels Gas und Kühlkörper.

(30) Priorität: 21.03.78 DE 2812334

(43) Veröffentlichungstag der Anmeldung:
03.10.79 Patentblatt 79/20

(45) Bekanntmachung des Hinweises auf die Patenterteilung:
25.11.81 Patentblatt 81/47

(84) Benannte Vertragsstaaten:
BE DE FR GB SE

(56) Entgegenhaltungen:
US-A-2 909 714
US-A-3 592 260

(73) Patentinhaber: SIEMENS AKTIENGESELLSCHAFT Berlin
und München, Postfach 22 02 61, D-8000 München 22 (DE)

(72) Erfinder: Weber, Jürgen, Dr., Erlenfeld 29,
D-8520 Erlangen (DE)
Erfinder: Salanki, Tibor, Dr., Kulmbacher Strasse 1,
D-8520 Erlangen (DE)
Erfinder: Scherbaum, Friedrich, Rennesstrasse 21,
D-8520 Erlangen (DE)
Erfinder: Hangs, Werner, Eskilstunastrasse 25,
D-8520 Erlangen (DE)

Verfahren zur Kühlung elektrischer Bauelemente mittels Gas und Kühlkörper

Die Erfindung betrifft ein Verfahren zur Kühlung elektrischer Bauelemente zur Kühlung mit Gas und einem Kühlkörper mit mindestens einer Außenfläche, die zur wärmeleitenden Verbindung mit den zu kühlenden Bauelementen bestimmt ist, wobei das Gas in geschlossenen, als Schlitze zwischen zur Außenfläche senkrecht stehenden Kühlrippen realisierten Kühlkanälen von Eintritts- zu Austrittsöffnungen strömt.

Eine derartige Anordnung ist Teil eines Kühlkörpers nach der US-PS 3 592 260. Der bekannte Kühlkörper besteht aus einer massiven Aluminiumplatte, die eine Ausnehmung für einen Radiallüfter besitzt. Weiterhin sind in der Aluminiumplatte senkrecht zu den Außenflächen stehende Kühlrippen ausgeformt, die radial bzw. fächerförmig von einer Öffnung der Ausnehmung für den Lüfter weg verlaufen. Mit diesen Kühlrippen sind die geschlossenen, schlitzförmigen Kühlkanäle realisiert, deren Breite von der Öffnung in der Lüfterausnehmung zu den Austrittsöffnungen der Kühlkanäle aus dem Kühlkörper zunimmt. Mit diesen fächerförmigen, von der Öffnung der Lüfterausnehmung weg verlaufenden Kühlrippen wird die Führung des Kühlmediums zu elektrischen Bauelementen hin verbessert, die besonders gekühlt werden müssen. Zur weiteren Verbesserung der Kühlluftführung sind mit Abdeck- bzw. Strömungsleitplatten Kühlkanäle im Bereich der Öffnung der Lüfterausnehmung abgedeckt. Nachteilig ist bei diesem Kühlkörper, daß die vom Lüfter in den Kühlkörper angesaugte Luft dort komprimiert wird, womit Wärme erzeugt wird, die vom Kühlkörper zusätzlich aufgenommen werden muß.

Aus der DE-OS 2 502 472 ist ein Kühlkörper bekannt, bei dem Kühlrippen zwischen zwei parallelen Grundplatten befestigt sind. Die Kühlrippen sind ebenfalls senkrecht zu den Grundplatten und zueinander parallel angeordnet. Die Kühlrippen bilden zusammen mit den beiden Grundplatten die geschlossenen Kühlkanäle, wobei das Kühlmittel, im Anwendungsbeispiel Luft, parallel zu den Kühlrippen und den Grundplatten strömt. Die Querschnitte der Kühlkanäle bleiben von den Eintrittsöffnungen zu den Austrittsöffnungen konstant. Zur Herstellung dieses Kühlkörpers werden die Kühlrippen in Nuten der Grundplatte eingepreßt. Durch dieses Herstellungsverfahren wird es möglich, die Kühlrippen sehr eng nebeneinander anzuordnen. Das ist insbesondere dann wichtig, wenn der zur Kühlung zugeführte Gasstrom einen kleinen Querschnitt, aber hohen Druck besitzt.

Gasströme mit kleinem Querschnitt und großen Druck werden z. B. zur Kühlung von Thyristoren in Hochspannungsanlagen benötigt. In der DE-PS 2 530 017 ist beispielsweise eine Anordnung beschrieben, bei der den Kühldosen einer gasisolierten Thyristoranordnung für Hochspannungsanlagen ein Kühlmittel durch Stützer mit Strömungskanälen zugeführt wird. Die Kühlmittelleitung kann im Stützer schraubenförmig geführt sein, um die Isolierstrecke zu vergrößern. Dabei können nur kleine Querschnitte für die Kühlmittelleitung verwendet werden, so daß ein hoher Druckabfall auftritt. Deshalb ist nur eine Kühlung mit verhältnismäßig hohem Eintrittsdruck des Kühlmittels und kleinem Kühlkanalquerschnitt möglich.

Die bekannten Anordnungen zur Gaskühlung bei hohem Druck zeigen eine verhältnismäßig hohe Geräuschentwicklung beim Austritt des Gases aus den Kühlkanälen. Mit den kleinen Kühlkanalquerschnitten ist eine ausreichende Kühlwirkung nur mit größerem Aufwand zu erzielen.

Aufgabe der Erfindung ist es, ein Verfahren der eingangs genannten Art zur Kühlung elektrischer Bauelemente mit Gas bei hohem Druck des Gases so auszugestalten, daß das Kühlvermögen des Gases gut ausgenützt wird bei geringer Geräuschentwicklung.

Erfindungsgemäß wird diese Aufgabe dadurch gelöst, daß ein Kühlkörper verwendet wird, bei dem der Querschnitt der Kühlkanäle von den Eintrittsöffnungen zu den Austrittsöffnungen zunimmt, und daß das Gas den Eintrittsöffnungen unter Druck zugeführt ist und beim Durchströmen der Kühlkanäle im Kühlkörper entspannt wird. Die erhöhte Wärmeaufnahme des Gases bei der Entspannung im Kühlkörper trägt wesentlich zur Wärmeabfuhr aus dem Kühlkörper bei. Da das Gas mit geringer Druckdifferenz gegenüber dem umgebenden Medium aus den Kühlkanälen austritt, wird zusätzlich die Geräuschentwicklung wesentlich vermindert. Durch die Veränderung der Schlitzhöhe im Kühlkörper ist außerdem eine starke Vergrößerung des Kühlkanalquerschnitts und damit eine starke Entspannung des Kühlmediums gegeben.

Zusätzlich kann die Breite der Schlitze von den Eintritts- zu den Austrittsöffnungen zunehmen. Mit dieser Ausgestaltung wird in einfacher Weise eine zusätzliche Querschnittsvergrößerung der Kühlkanäle und damit eine noch bessere Kühlwirkung erreicht. Eine Zunahme der Breite der Schlitze kann beispielsweise durch Verringerung der Rippendicke oder durch fächerförmige Anordnung der Kühlrippen erreicht werden.

Beim Kühlkörper der obengenannten Art kann die Zunahme des Querschnitts der Schlitze von den Eintritts- zu den Austrittsöffnungen so groß sein, daß die Abkühlung des Gases durch Entspannung etwa die vom Kühlkörper an das Gas abgeführte Wärmeenergie kompensiert. Damit wird erreicht, daß die Austrittstemperatur des Gases aus dem Kühlkörper etwa so groß ist wie die Eintrittstemperatur. Das aus dem Kühlkörper mit relativ niedrigem Druck austretende Gas kann dann zur Kühlung weiterer Bauelemente, z. B. von Beschaltungsbaugruppen von Thyristoranordnungen verwendet werden.

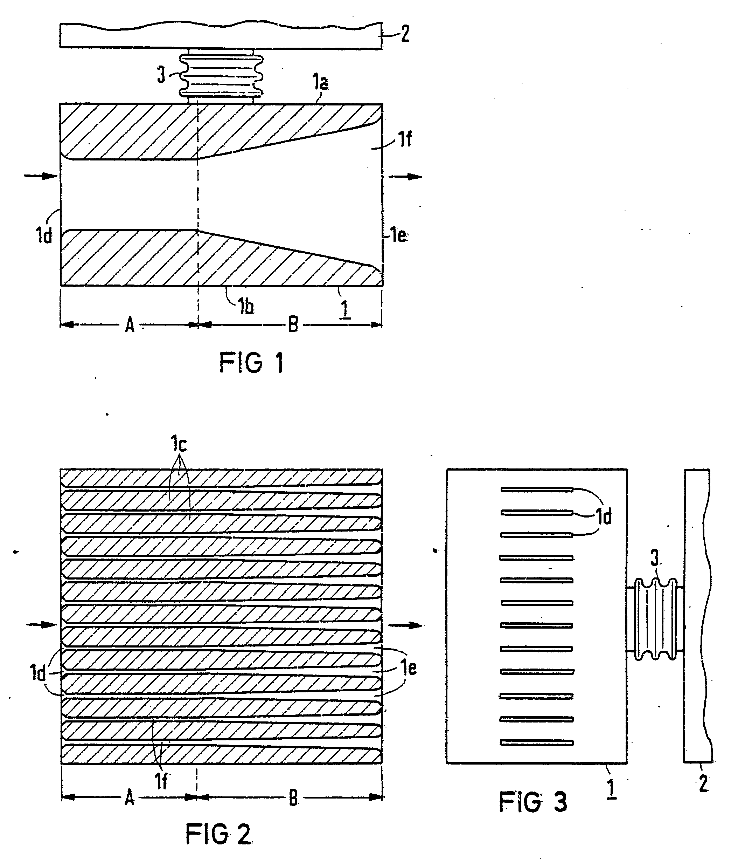

Ausführungsformen des erfindungsgemäß verwendeten Kühlkörpers werden im folgenden beispielhaft anhand der Figuren 1 bis 6 beschrieben. Dabei sind in den einzelnen Figuren gleiche Bauteile mit gleichen Bezugszeichen versehen.

Die Figuren 1 bis 3 zeigen eine Ausführungsform des Kühlkörpers 1 mit Kühlrippen 1c, wobei die Breite der als Schlitze ausgebildete Kühlkanäle 1f von den Eintrittsöffnungen 1d zu den Austrittsöffnungen 1e der Kühlkanäle 1f zunimmt und auch die Höhe der Kühlkanäle 1f von den Eintrittsöffnungen 1d zu den Austrittsöffnungen 1e zunimmt. Dabei zeigt Figur 1 einen Schnitt parallel zu den Kühlrippen 1c, Figur 2 zeigt einen Schnitt parallel zur Außenfläche 1a und Figur 3 eine Draufsicht in Richtung der Eintrittsöffnungen 1d. Die Figuren 1 bis 3 sollen im folgenden gemeinsam erläutert werden.

Der Kühlkörper 1 weist zwei zueinander parallele Außenflächen 1a und 1b auf, wobei im gezeigten Beispiel auf der Außenfläche 1a ein zu kühlender Scheibenthyristor 3 als elektrisches Bauelement aufliegt. Der Scheibenthyristor 3 liegt zwischen dem beschriebenen Kühlkörper 1 und einem weiteren gleichartigen Kühlkörper 2, der in den Figuren nur angedeutet ist. Im Kühlkörper 1 verlaufen zwischen den Kühlrippen 1c die Kühlkanäle 1f als Schlitze. Der Kühlkörper 1 ist für Zwangskühlung ausgelegt. Das Kühlgas tritt mit relativ hohem Druck an den Eintrittsöffnungen 1d ein und mit wesentlich niedrigerem Druck an den Austrittsöffnungen 1e wieder aus. Die Dicke der Kühlrippen 1c nimmt von den Eintrittsöffnungen 1d zu den Austrittsöffnungen 1e ab, so daß die Breite der als Schlitze ausgebildeten Kühlkanäle 1f in dieser Richtung zunimmt, wie Figur 2 deutlich zeigt. Dabei ist die Dicke der Kühlrippen 1c in einem Bereich A zunächst konstant und nimmt dann in einem Bereich B ab.

Die Höhe der Kühlkanäle 1f in der Richtung senkrecht zu den beiden Grundflächen 1a, 1b nimmt von den Eintrittsöffnungen 1d zu den Austrittsöffnungen 1e ebenfalls zu. Auch hierbei ist die Höhe der Kühlkanäle 1f in dem Bereich A zunächst konstant und nimmt dann in dem Bereich B zu.

Die Kühlkanäle 1f besitzen also zwei Bereiche A und B, wobei im Bereich A der Querschnitt konstant ist und im Bereich B der Querschnitt zunimmt. Der Bereich eintretende dient als Beruhigungszone für das einströmende Gas zur Vergleichmäßigung der Druck- und Strömungsverteilung über den Querschnitt jedes Kühlkanals 1f.

Im Bereich B jedes Kühlkanals 1f nimmt sowohl die Breite als auch die Höhe des Kühlkanals 1f zu. Damit ergibt sich eine starke Erhöhung des Querschnitts in Richtung zu den Austrittsöffnungen 1e der Kühlkanäle 1f in diesem Bereich B. Das mit relativ hohem Druck in die Eintrittsöffnungen 1d eintretende Kühlgas kann sich also in den Kühlkanälen 1f entspannen, und die Temperatur des Kühlgases würde sich ohne Wärmezufuhr gemäß den Druckverhältnissen vermindern. Die Wärmeaufnahme des Kühlmittels und damit auch die Wärmeabfuhr aus dem Kühlkörper 1 wird also wegen der größeren Temperaturdifferenz zwischen Kühlkörper und expandiertem Medium erhöht. Bei herkömmlichen Kühlkörpern mit konstantem Querschnitt der Kühlkanäle findet die Ausdehnung und damit Abkühlung des Kühlgases erst bei Austritt aus dem Kühlkörper statt und trägt damit nicht mehr zur Kühlung des Kühlkörpers bei.

Die Querschnittszunahme der Kühlkanäle 1f kann man so bemessen, daß die bei der Entspannung des Kühlmittels auftretende Abkühlung die Erwärmung durch die Wärmeabfuhr aus dem Kühlkörper 1 annähernd kompensiert. Die Austrittstemperatur des Kühlgases ist dann etwa gleich der Eintrittstemperatur. Damit steht auch für die anschließende Durchströmung weiterer Bauelemente, z. B. der Ansteuer- und Beschaltungsbaugruppen, mit dem Kühlgas die gleiche niedrige Kühlmitteltemperatur zur Verfügung. Durch entsprechende Gestaltung der Querschnittszunahme der Kühlkanäle 1f läßt sich auch die Wärmeübergabe der Rippen in Abhängigkeit von der Änderung des Wärmeleitwertes innerhalb des Kühlkörpers längs der Strömungsrichtung des Kühlgases optimieren.

Bei herkömmlichen Kühlkörpern, die mit hohem Druck des Kühlgases arbeiten, tritt beim Austritt des Kühlgases aus dem Kühlkörper wegen der plötzlichen Entspannung eine starke Geräuschentwicklung auf. Der erfindungsgemäße Kühlkörper 1 weist wegen der gezielten Entspannung des Kühlgases innerhalb des Kühlkörpers eine geringe Geräuschentwicklung auf.

Ein Kühlkörper 1 der beschriebenen Art läßt sich aus mehreren Teilen durch Löten oder Pressen oder aus einem Stück mit sogenannten elektrochemischen Abtragungsverfahren oder mit Druckgußtechnik herstellen.

## Patentansprüche

1. Verfahren zur Kühlung elektrischer Bauelemente mittels Gas und einem Kühlkörper mit mindestens einer Außenfläche, die zur wärmeleitenden Verbindung mit den zu kühlenden Bauelementen bestimmt ist, wobei das Gas in geschlossenen, als Schlitze zwischen zur Außenfläche senkrecht stehenden Kühlrippen realisierten Kühlkanälen von Eintritts- zu Austrittsöffnungen strömt, dadurch gekennzeichnet, daß der Querschnitt der Schlitze von den Eintrittsöffnungen her gesehen zunimmt, und daß das Gas den Eintrittsöffnungen (1d) unter Druck zugeführt ist und beim Durchströmen der Schlitze (1f) von den Eintrittsöffnungen (1d) zu den Austrittsöffnungen (1e) entspannt wird.

2. Kühlkörper zur Durchführung des Verfahrens nach Anspruch 1, dadurch gekennzeichnet, daß die Höhe und/oder die Breite der Schlitze (1f) von der Eintritts- (1d) zu den Austrittsöffnungen (1e) zunimmt.

3. Verfahren nach Anspruch 1, dadurch gekennzeichnet, daß die Zunahme des Querschnitts der Schlitze (1f) des verwendeten Kühlkörpers von den Eintrittsöffnungen (1d) zu den Austrittsöffnungen (1e) so groß ist, daß die Abkühlung des Gases durch Entspannung etwa die vom Kühlkörper (1) an das Gas abgeführte Wärmemenge kompensiert.

## Claims

1. A process for cooling electric components by means of a gas and a cooling body having at least one outer surface intended for heat-conducting connection to the components to be cooled, wherein the gas flows in closed cooling channels formed by slots extending between cooling fins arranged at right angles to the outer surface, from inlet openings to outlet openings, characterised in that from the inlet openings, the cross-section of the slots increases, and that the gas is fed to the inlet openings (1d) under pressure and is expanded on flowing through the slots (1f) from the inlet openings (1d) to the outlet openings (1e).

2. A cooling body for carrying out the process as claimed in claim 1, characterised in that the height and/or the width of the slots (1f) increases from the inlet openings (1d) to the outlet openings (1e).

3. A process as claimed in claim 1, characterised in that the increase in the cross-section of the slots (1f) of the cooling body used, from the inlet openings (1d) to the outlet openings (1e) is so great that the cooling of the gas by means of expansion to some extent compensates for the amount of heat dissipated by the cooling body (1) to the gas.

## Revendications

1. Procédé pour refroidir des composants électriques à l'aide d'un gaz et d'un diffuseur de chaleur comportant au moins une surface extérieure qui est destinée à assurer la liaison thermoconductrice avec les composants à refroidir, le gaz circulant dans des canaux de refroidissement fermés, réalisés sous la forme de fentes entre des nervures de refroidissement perpendiculaires à la surface extérieure, depuis des ouvertures d'entrée en direction d'ouvertures de sortie, caractérisé en ce que la section transversale des fentes augmente à partir des ouvertures d'entrée et que le gaz est envoyé sous pression aux ouvertures d'entrée (1d) et se détend lors de l'écoulement par les fentes (1f) depuis les ouvertures d'entrée (1d) en direction des ouvertures de sortie (1e).

2. Diffuseur de chaleur pour la mise en oeuvre du procédé selon la revendication 1, caractérisé en ce que la hauteur et/ou la largeur des fentes (1f) augmente à partir des ouvertures d'entrée (1d) et en direction des ouvertures de sortie (1e).

3. Procédé selon la revendication 1, caractérisé en ce que l'accroissement de la section transversale du diffuseur de chaleur utilisé depuis les ouvertures d'entrée (1d) en direction des ouvertures de sortie (1e) est suffisamment important pour que le refroidissement du gaz par détente compense approximativement la quantité de chaleur transférée du diffuseur de chaleur (1) au gaz.

FIG 1

FIG 2

FIG 3